# EUROPEAN PATENT SPECIFICATION

(11) **EP 0 297 898 B1**
(45) Date of publication and mention of the grant of the patent: **11.10.1995**
(21) Application number: 88306008.9
(22) Date of filing: 01.07.1988
(51) Int. Cl.: H01L 21/31

(54) **Method of dry etching**
Verfahren zum Trockenätzen
Procédé pour attaque sèche

(30) Priority: 02.07.1987 JP 165860/87
(43) Date of publication of application: 04.01.1989
(73) Proprietor: KABUSHIKI KAISHA TOSHIBA, Kawasaki-shi, Kanagawa-ken 210 (JP)
(72) Inventor: Arikado, Tsunetoshi c/o Patent Division, 1-1, Shibaura 1-chome Minato-ku Tokyo105 (JP); Horike, Yasuhiro c/o Patent Division, 1-1, Shibaura 1-chome Minato-ku Tokyo105 (JP); Sekine, Makoto c/o Patent Division, 1-1, Shibaura 1-chome Minato-ku Tokyo105 (JP); Okano, Haruo c/o Patent Division, 1-1, Shibaura 1-chome Minato-ku Tokyo105 (JP)
(74) Representative: BATCHELLOR, KIRK & CO.

(56) References cited:
- EP-A- 0 258 698
- EP-A- 0 289 131
- WO-A-86/03886
- SOLID STATE TECHNOLOGY, vol. 23, no. 11, November 1980, pp. 85-91, Port Washington, New York, US; G.C. SCHWARTZ et al.: "Reactive ion etching in chlorinated plasmas"
- APPLIED PHYSICS LETTERS, vol. 48, no. 17, April 1986, pp.1165-1166, American Institute of Physics, Woodbury, New York, US; N. HAYASAKA et al.: "Photo-assisted anisotropic etching of phosphorus-doped polycrystalline silicon employing reactive species generated by a microwave discharge"
- PATENT ABSTRACTS OF JAPAN, vol. 8, no. 247 (E-278)[1684], 13th November 1984 ; & JP-A-59 124 135
- EXTENDED ABSTRACTS, vol. 82-1, May 1982, abstract no. 212, pp. 341-342, Pennington, New Jersey, US; E.R. SIRKIN : "Etching of Si3N4 in a NF3 plasma"
- JOURNAL OF VACUUM SCIENCE & TECHNOLOGY B, vol. 4, no.3, Second Series, May/June 1986, pp. 696-700, American Vacuum Society, Woodbury, NY, US; T. ONO et al.: "Reactive ion stream etching utilizing electron cyclotron resonance plasma"

## Description

This invention relates to a method of dry etching. More particularly, the invention relates to a method of selective dry etching for multi-layered structures.

In recent years, the degree of integration of semiconductor integrated circuits has advanced, and circuit pattern sizes have become finer. The thickness of various thin films utilised in fabrication processes for semiconductor integrated circuits has been reduced with the reduction in size of the circuit patterns. For instance, the thickness of a gate oxide film of a MOS type integrated circuit may be as small as 10nM (100 Å.)

The reactive ion etching process is well known as one method of etching materials, such as polycrystalline silicon, etc. The process includes the following steps:- The object to be etched is disposed between a pair of parallel plate electrodes provided in a vacuum chamber and a reactive gas is introduced therein. Thereafter, the reactive gas is caused to support a discharge by applying radio frequency power to the electrodes. As a result, gas plasma is generated from the discharge in the reactive gas. The wafer is etched by the gas plasma.

In addition to reactive ion etching, plasma etching, ECR type dry etching, ion beam etching and photo excited etching are known methods of etching. These etching processes are also performed by operating chemically or physically on the wafer with ions of the activated reactive gas.

Reactive ion etching is largely classified into two types. One is the cathode coupled type in which the object is disposed on the electrode which is supplied with the radio frequency power. The other method is the anode coupled type in which the object to be etched is disposed on a grounded electrode. The electrode which supports the object is usually water-cooled to prevent thermal degradation of the photo-resist formed on the surface of the wafer. The wafer is held electrostatically or mechanically on the electrode or it may be merely placed on the water-cooled electrode.

In all of the above-mentioned radio frequency coupled types, there is an ion assisted chemical reaction to carry out the etching. Ions existing in the plasma bombard the wafer and the chemical reaction carries out the etching naturally using an active radical of the reactive gas. The ion assisted chemical reaction is the most suitable for anisotropic etching, and the chemical reaction is the most suitable for isotropic etching. The etching direction is more satisfactory and the shape of the boundary of the etched portion is straighter with the ion assisted chemical reaction.

If the contact between the wafer and the water-cooled wafer holder is strong, this is sufficient to prevent the deterioration of the photo-resist formed on the surface of the wafer. If the adhesion is not strong, the wafer is not cooled sufficiently to suppress the deterioration of the photo-resist.

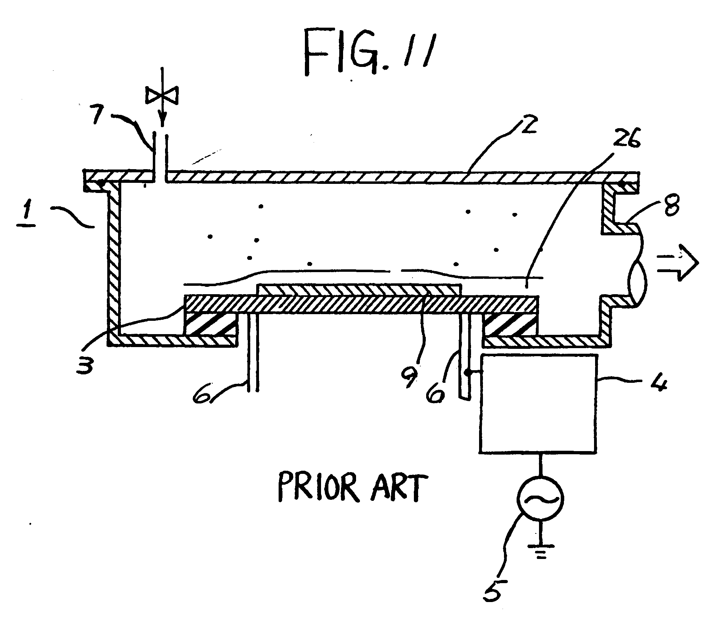

Problems encountered with conventional etching apparatus will now be described. Figure 11 of the accompanying drawings is a sectional view of a parallel plate type dry etching apparatus of the cathode coupled type. A pair of parallel plate electrodes comprising an anode 2 and a cathode 3 are within a vacuum chamber 1. The anode 2 is grounded, and the cathode 3 is supplied with radio frequency power of 13.56 MHz through a matching box 4 from a source 5. The cathode is water-cooled with pipes 6 serving as supply and return pipes. Etching gases are introduced from a gas flow tube 7 into the vacuum chamber 1, and are exhausted through an exhaust port 8. A substrate 9 is disposed on the cathode 3.

In this conventional etching apparatus, the cathode forms a part of the vacuum chamber. The coolant at ambient temperature flows through the cathode. However, water vapour liquifies and condensation forms on surfaces of the cathode 3 based on the temperature difference between the inner temperature of the vacuum chamber 1 and the temperature of the cathode 3. As a result, water is present inside the apparatus, and electrical short circuits can occur, for example, on the matching box 4.

A rubber O-ring is used to vacuum-seal the cathode side. This is generally heat-resisting. However, the rubber O-ring may harden with the drop in the temperature of the cathode, and leakage may then occur. There are similar problems in other conventional etching apparatus.

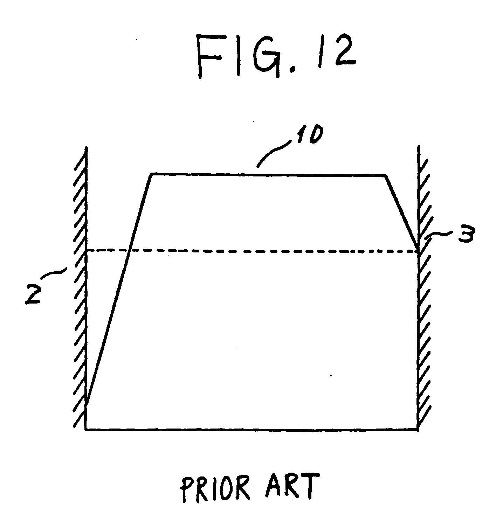

Problems caused in the etching of polycrystalline silicon using the conventional etching apparatus will be explained with reference to Figure 12 which shows the potential distribution in a reactive ion etching apparatus. Reference numbers 3 and 2 of Figure 12 indicate the cathode and anode of the dry etching apparatus, respectively. The highest electric potential in the discharge space in the vacuum chamber is the plasma potential 10 shown in Figure 12. Electrons are stored on all surfaces contacted with the plasma, so that the electron transfer is very great in comparison with the ions. As a result, the electric potential becomes lower than the plasma potential 10.

A big drop of the cathode voltage occurs near the surface of the cathode 3 to maintain the discharge, but the difference of the potential reaches only the plasma potential 10 near the surface of the anode 2. Therefore, the cathode coupled type has a good etching direction to contribute to the ion assisted chemical reaction. The anode coupled type has a low ion bombardment energy. Thus, the etching direction is not as accurate as the cathode coupled type. As a result, an undercut or inversely tapered feature on the boundary of the etched part is apt to occur. Accordingly, the cathode coupled type is better from the view point of working efficiency, and this type is more suitable as a future fine pattern forming method of the sub-micrometer order.

When the object to be etched comprises a first film with a second film over the first, the selectivity of the material of the second film to the material of the first film is important in addition to the working shape. For example, in an etching process of the gate material of polycrystalline silicon, when the thickness of the gate oxide film becomes 10nM (100 Å) or less, a very high selectivity is required. In the cathode coupled type, the surface is dissolved or activated independently of the character of the material, because the ion bombardment energy is large. As a result, the selectivity of the cathode coupled type is generally lower than that of the anode coupled type.

Thus, the selectivity is good but the working efficiency is not good with the anode coupled type, and the working efficiency is good but the selectivity is not good in the cathode coupled type. When a regular MOS transistor is manufactured by the anode coupled type method, the working efficiency causes the scattering of the channel length. On the other hand, in the cathode coupled type, etching does not stop on the gate oxide film and progresses to the under silicon substrate. This causes deterioration of the yields.

In recent years, an ECR (Electron Cyclotron Resonance) discharge method has been developed and applied to the etching of polycrystalline silicon. A selectivity of 30 or more is obtained, so that the ion energy is multiplied greatly. However, the working efficiency is lower than the cathode type so that the ion energy is small, i.e., similar to the anode coupled type ion etching apparatus.

The reader will find further guidance to the state of the art from WO 86/03886 with respect to which claim 1 of this document is precharacterised. It will be apparent to the reader that in WO 86/03886 the temperature of the cathode supporting the wafer is controlled. However, the actual wafer temperature is of the order of 10K higher because of thermal resistances between the cathode and wafer

Accordingly, an object of the invention is to provide a method of dry etching capable of producing a multi-layered structure having substantially a vertical etching wall and a high selectivity.

According to the present invention, a method in which a wafer composed of a first film and a second film overlying the first film is etched, said first film consisting of silicon oxide and the second film consisting of polycrystalline silicon, comprising the steps of disposing the wafer in a vacuum chamber, cooling the wafer, and introducing a reactive gas to the chamber to etch the wafer characterised in that the wafer is cooled to a temperature between 243K and 263K during etching so that a thin film including at least one element of the first film selectively deposits on the first film.

In order that the invention may be more readily understood, it will now be described, by way of example only, with reference to the accompanying drawings, in which:-
Figure 1 is a graphical representation of the relation between the reciprocal of the temperature of a substrate and the etching rate;
Figures 2a to 2c are sectional views of etched objects using the invention (b) and the conventional process (c);
Figure 3 illustrates, partly in section, an apparatus suitable for the method of the invention;
Figure 4 is a graphical representation describing the relation between the reciprocal of the temperature of a substrate and the etching rate of the invention;
Figures 5 and 6 illustrate, partly in section, another apparatus suitable for the method of the invention;
Figures 7a and 7b illustrate, partly in section, further embodiments of the invention;
Figures 8 and 10 illustrate, partly in section, further apparatus suitable for the method of the invention; and
Figures 9a and 9b are sectional views of etched objects using the conventional process and the process of the invention.

The inventors have discovered the relationship of the temperature dependence of the etching rates of polycrystalline silicon, and silicon oxide film using reactive gases, such as chlorine, etc. It has been found that the etching rate varies linearly according to the reciprocal of the temperature in polycrystalline silicon, etc. However, it was also found that there are two rates of temperature dependence in a silicon oxide film. Namely, the variation at higher temperatures is smaller than at lower temperatures. In other words, the selectivity improves considerably at lower temperatures. Furthermore, it has been ascertained that other materials also have a high selectivity.

If the temperature of the surface of the substrate is high, etching products, e.g. SiCl₄, desorbed from the surface of the object by vaporisation, etc., result in a reaction between the reactive gases and the object, e.g. polycrystalline silicon. Continuously, the surface of the object is activated and decomposed, and the ion assisted chemical reaction makes progress.

However, when the object is cooled to a temperature below 273K (0°C), etching products, e.g., SiCl₄ having low vapour pressure, are hard to vaporise from the surface of the object. Namely, etching products cover the surface of the object, and protect the surface of the silicon oxide film from the ion bombardment. Therefore, the silicon oxide film is excited and decomposed together with etching products. Thus, the degree of desorption of the silicon oxide film is decreased.

When the under layer of a multi-layered object is silicon oxide, silicon is generated by decomposition of SiCl₄ and oxygen is generated by decomposition of SiO₂. The generated silicon and oxygen form SiO₂ again. Therefore, the etching rate of SiO₂ falls greatly and the etching rate improves.

Furthermore, the chemical reaction using active species (radicals) having no charge generated from the decomposition of the reactive gas has a greater temperature dependence than the ion assisted chemical reaction. The under cutting of an etched wall becomes smaller the lower the substrate temperature, consequently, substantially flat etching of a substrate can be carried out.

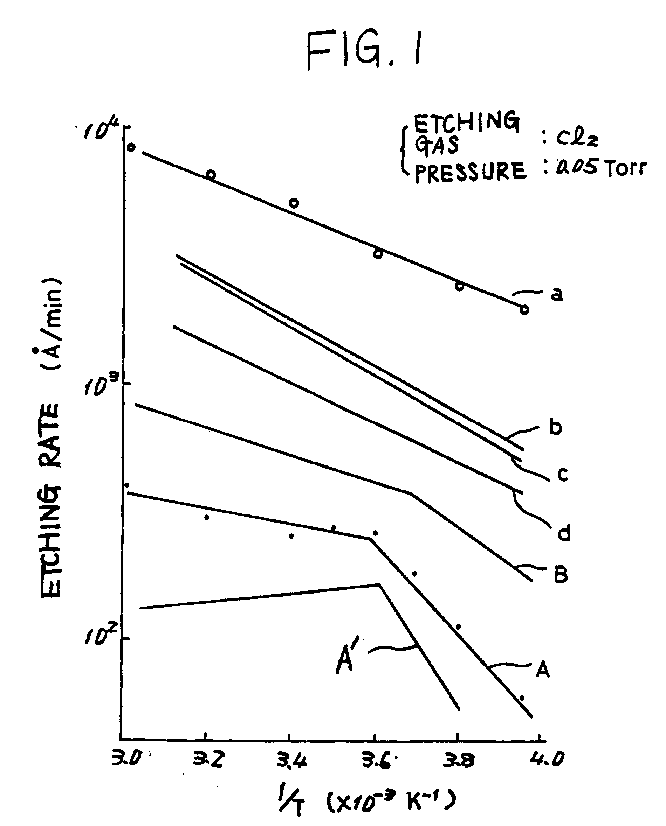

The relation between the reciprocal of the substrate temperature and the etching rate when the second film formed on the first film is selectively etched will be explained referring to Figure 1. A silicon oxide film (A) and for comparison a silicon nitride film (B) were used as the first film, and phosphorous doped polycrystalline silicon (a) as the second film with, molybdenum silicide (b), tungsten silicide (c), and titanium silicide (d) being used for comparison.

The dry etching apparatus used to measure these characteristics was basically the same as the apparatus shown in Figure 11, except for the cooling means, which could cool to below 273K (OC) temperatures. Chlorine gas was introduced into the vacuum chamber as the reactive gas, and the pressure was set to 0.05 Torr (1T ≡ 133.3 Pa). The output of the radio frequency power was 200 Watt.

In Figure 1, the ordinate represents the etching rate and the abscissa represents the reciprocal of the temperature in K. The etching rate of the second film falls linearly with reduction of temperature. The etching rate of the first film falls with the reduction of the temperature, but an inflection point is evident near 273K (OC) (3.6 x 10⁻³ K⁻¹). The etching rate falls more rapidly below the temperature of the inflection point. As a result, the selectivity increased below the inflection point.

As a result of this phenomenon, the fall of the substrate temperature complicates the desorbing of etching products from the surface of the substrate, and reduces the vapour pressure. Thus, surface concentration becomes high. In this embodiment, the etching product is the SICl₄ formed by the reaction between chlorine gas and polycrystalline silicon. When the first film is silicon oxide, the ion bombardment forms the silicon oxide again. This is because oxygen reacts with etching products, including silicon. Namely, although silicon oxide is desorbed by the etching reaction from the surface of the substrate, silicon oxide is deposited again by the CVD reaction using gaseous phase etching products. As a result, the etching rate of the silicon oxide film falls remarkably and the selectivity is improved.

In the case of the comparison silicon nitride film (B), a tendency similar to that of the silicon oxide film (A) is shown. The best selectivity mode is obtained when polycrystalline silicon (a) was etched selectively on silicon oxide (A) and with this combination the most suitable cooling temperature range was 243K (-30C) to 263K (-10C).

The inflection point in the relation of the reciprocal of the temperature and the etching rate changes with pressure. When the pressure is low, the temperature of the inflection point is also low. The inclination of the characteristic may become positive (line A′) and the inclination of the negative characteristic changes at the inflection point to a much steeper drop.

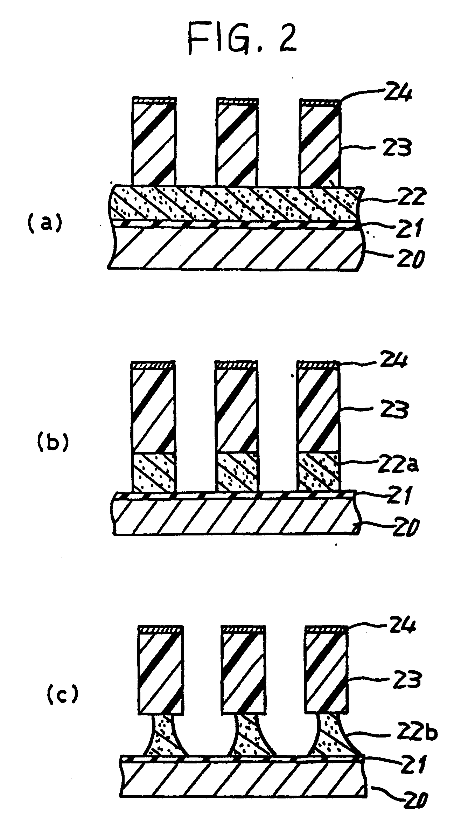

Figures 2a to 2c show sectional views of objects etched in comparison with the invention and the conventional process. The object is comprised of a P-type silicon substrate (the crystal direction is 100) 20, a first film 21 of SiO₂ formed on the substrate 20 by a CVD process and a second film 22 of polycrystalline silicon formed on the first film 21. A photo-resist film 23 carrying a Spion glass layer 24 is formed on the second film.

When etching takes place, the polycrystalline silicon film 22a is etched with the side wall flat and no undercutting when the substrate is cooled to 253K (-20C) (shown in Figure 2b). On the other hand, at ambient temperature, etching caused the side walls to be undercut, as shown in Figure 2c.

Essentially, the phosphorous doped polycrystalline silicon is apt to experience side etching from reacting naturally with the chlorine radical. However, in the reactive ion etching, decomposition products stick to the side wall of the polycrystalline silicon. The side wall is protected from the attack of the radical. The side etching is prevented and vertical etching is carried out. Therefore, when a multi-layered photo-resist without the direct exposure of the plasma is used as a mask, a side wall protecting layer is not formed. As a result, the side etching occurs at normal temperatures. However, the temperature dependence of the chemical reaction effected by the radical is greater than the temperature dependence of the ion assisted chemical reaction. Moreover, the mobility of the radical on the etching surface is small at low temperature. Thus side etching is prevented on the polycrystalline silicon layer at 253K (-20C).

A similar effect is obtained in the cathode coupled and the anode coupled type of etching apparatus. The invention improved not only the selectivity but also working efficiency of the anode coupled type.

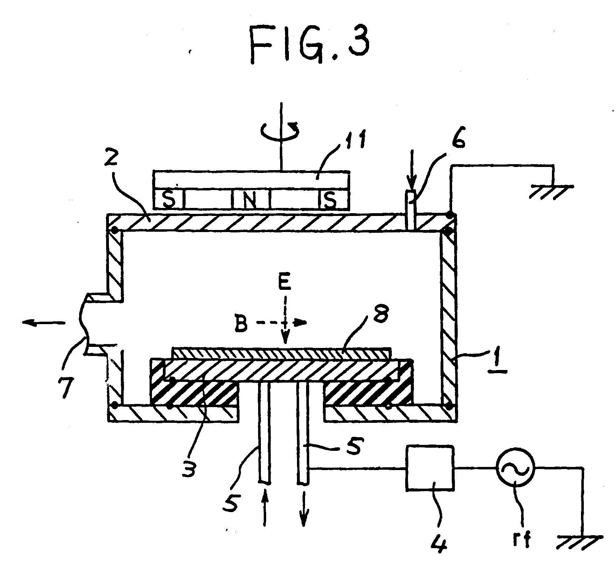

Figure 3 shows a dry etching apparatus suitable for the method of the invention. Figure 3 is basically similar to Figure 11, with the same parts described by the same references. This apparatus has two additional features. First, the cooling means 5 cools to below the temperature of the inflection point. This increases the inclination of the negative characteristic in the reaction. Also, a magnetic field generating means 11 is provided in a vacuum chamber 1.

The magnetic field generating means 11 includes a magnet provided on an anode 2 and the magnet is rotatable eccentrically. Electrons perform cycloid movement in the crossed area at which applied magnetic field from the magnet to the cathode 3 and the direct current electric field E cross vertically. The high density magnetron plasma moves in this state close to the surface of the substrate 8 with eccentric rotation of the magnet, and high selectivity etching of the substrate is possible.

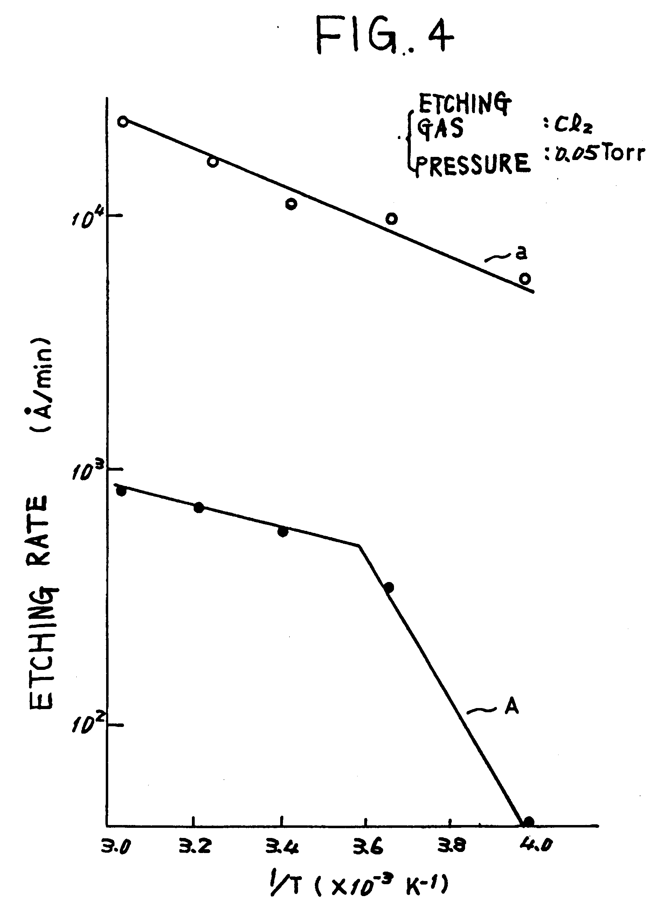

Figure 4 shows a graphical diagram describing the relation between the etching rate and the reciprocal of the temperature when the etching was performed with chlorine gas in the vacuum chamber. The gas pressure is 6.665Pa (0.05 Torr) and the radio frequency is 200 Watt. The phosphorous doped polycrystalline silicon film as the second layer is formed on the whole surface of the substrate 8 and the silicon oxide selectively patterned film as the first layer is formed on the second film. Figure 4 describes a similar characteristic of the above-mentioned embodiment without the magnetic field, but this embodiment using a magnetic field can obtain a higher selectivity.

In this embodiment the etching gas was chlorine gas. However other halogen gases are useful.

Other embodiments of the invention will now be explained. The etching process may be divided into two steps. An object to be etched, having the same structure as shown in Figure 2, is first etched by the normal relative ion etching. The second film is formed as a very thin film. Therefore, the object to be etched is etched with cooling. The etching progresses faster during the first step. This is useful, particularly when the second film is very much thicker than the first film.

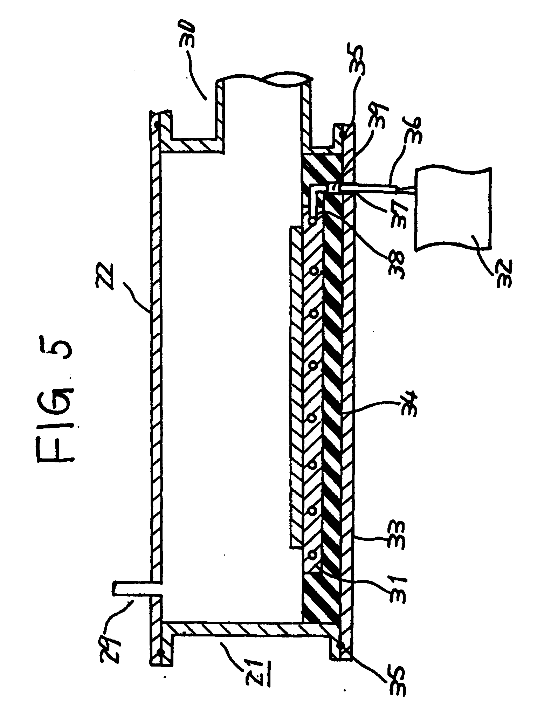

Figure 5 shows another type of etching apparatus suitable for the method of the invention. It is basically similar to the apparatus shown in Figure 11. This apparatus is the cathode coupled type. A cathode 31 which is not a part of the wall of the vacuum chamber is disposed on a bottom plate 33 by the vacuum chamber and separated by an insulator 34. The bottom plate 33 and the flange of the vacuum chamber are sealed in airtight manner by an insulating elastic O-ring 35. A pipe for the coolant passes through the bottom plate from the outside of the vacuum chamber. This portion (36) of the pipe is made of a ceramic material for heat insulation. The pipe is sealed to the bottom please 33 in airtight manner by way of a body of resin 37.

A stainless steel pipe 38 arranged in a spiral is buried inside the cathode. This pipe and the ceramic pipe 36 are jointed by a connector 39.

The coolant flows in the ceramic pipe 36 and the stainless steel pipe 38 through the temperature control means 32 which is capable of cooling below the temperature of the inflection point. Liquid nitrogen or fluon gas coolant may be used. The cooling system can cool the cathode to about 243K (-30°C). Therefore, this apparatus can carry out the etching with high selectivity.

Condensation is prevented by the insulator 34 provided inside the bottom plate 33 and, as a result, the danger of an electrical short is removed. Hardening of the O-ring and consequent leakage are prevented by the use of a silicon rubber O-ring.

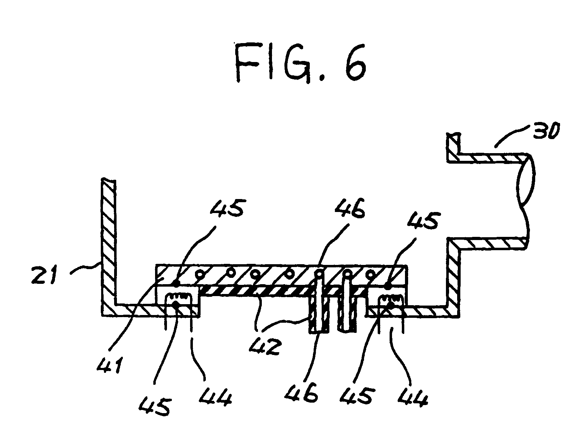

Figure 6 shows another apparatus suitable for the method of the invention which has another type of condensation prevention means. A pipe 46 directs the coolant into a cathode 41. The base of the cathode 41 is covered by a thick layer of heat insulating material 42. The vacuum sealing is carried out using an O-ring 45. A heater 44 is buried in the insulator to keep the temperature normal and to prevent hardening of the O-ring.

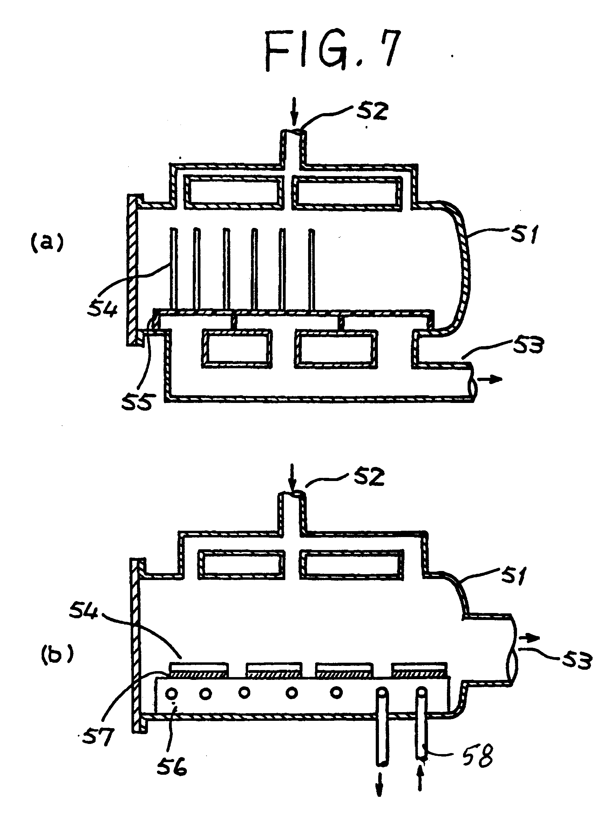

Figure 7a shows a view of a generally cylindrical plasma etching apparatus also suitable for the method of the invention. An etching gas is introduced through tubes 52, to a cylindrical vacuum chamber 17, and exhausted through an exhaust 53. A coil or an electrode (not shown) can supply radio frequency power and surrounds the quartz cylindrical vacuum chamber 51. The pressure of the etching gas is kept between 13.3 Pa - 133.3 Pa (0.1 - 1 Torr). The radio frequency power supplied to the etching gas is generated capacitively or inductively using the coil or electrode. Thus, the plasma is generated in the chamber and a wafer 54 is etched.

The wafer 54 to be etched is generally disposed on a quartz boat 55 and is floated electrically. As a result, the potential difference of the object is merely the difference of a plasma potential and a floating potential. The contribution of the ion assisted chemical reaction is small. The etching is mainly progressed by radicals. Therefore, the working shape of the object is isotropical.

Generally, the mixing gas composed of CF₄ and oxygen (including about 10%) is introduced and is used to etch the polycrystalline silicon film. In the conventional apparatus shown in Figure 7a, the high etching rate, e.g. about 20, is obtained between the phosphorous doped polycrystalline silicon film and the silicon oxide film, but the selectivity between a silicon nitride film and the silicon oxide film is small, e.g. about 5-6. The improvement of the selectivity is required to remove the silicon nitride in a LOCOS process.

Figure 7b shows an improved apparatus which has an improved cooling means to cool an object 54. Different parts from the conventional apparatus shown in Figure 7a are below. A printed board 57 is disposed on an object supporting holder 56, and the object 54 to be etched is chucked electrostatically. The object supporting holder 56 is cooled by the coolant supplied by a cooling pipe 58.

In this apparatus, the object is cooled to 253K (-20C) which is less than the temperature of the inflection point where the characteristic of the silicon oxide film changes similarly to that shown in Figure 5. As a result, chlorine of about 30% is added in the mixing gas of CF₄ and oxygen, the selectivity between the polycrystalline film and the silicon oxide film becomes 30 and the selectivity between the silicon nitride film and the silicon oxide film is improved 12 -15.

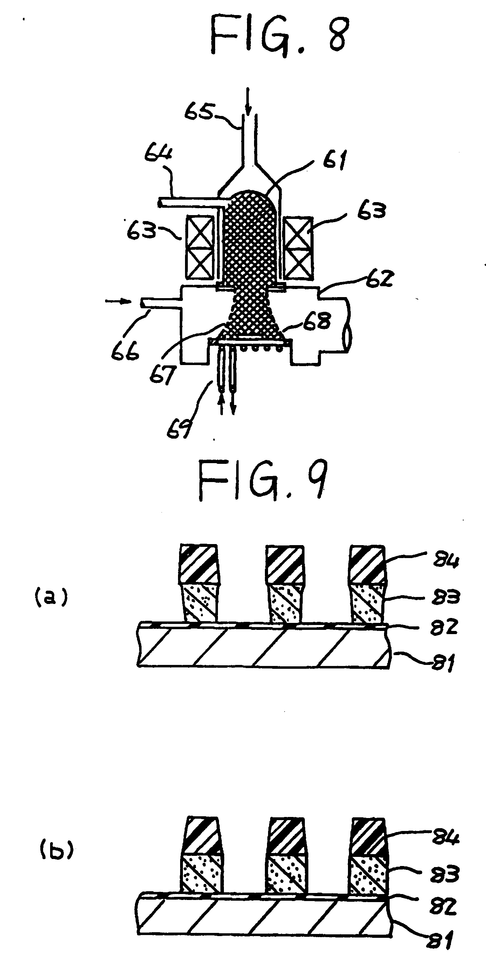

Figure 8 shows an ECR type dry etching apparatus which is comprised of a discharge chamber 61 made of quartz and an etching chamber 62 separated from the discharge chamber 61. A magnet 63 which generates a magnetic field of 0.0875 T (875) gauss surrounds the discharge chamber 61. Micro-wave radiation is supplied to the discharge chamber 61 through a micro-wave guide 64 from a micro-wave power source (not shown). An etching gas is introduced and discharged by pipes 65 and 66.

An object 67 to be etched is disposed on an object supporting holder 68 provided in the etching chamber 62. The object supporting holder has a cooling means 69. The cooling means 69 is connected to a temperature control means.
The ions generated by the ECR discharge in the discharge chamber are pushed out along a slope of a magnetic field and are bombarded about vertically on the object to be etched.

The apparatus is operated to provide the etching gas at low pressure, e.g., 0.1333Pa (10⁻⁴Torr). As a result, there are few radicals. This ECR etching apparatus is a kind of ion shower type etching apparatus. A feature of this apparatus is that the ion energy is small because the plasma potential is low and the object 67 floats electrically. A mixture of FS₆ and chlorine is used. This apparatus can obtain the etching rate of about 40 under the conditions of whole gas volume of flow 15 SCCM, pressure 39mPa (0.0003 Torr) and power of micro-wave 200 Watt.

A silicon oxide film 82 as a first film is formed on the substrate 81 and a phosphorous doped polycrystalline silicon film 83 as a second film is formed on the first film. A photo-resist film 84 used as a mask is covered selectively on the parts of the second film 83 which are not to be etched. The second film 83 of above-mentioned substrate is slightly side-etched (shown in Figure 9a) to become the overhanging shape.

When the above-mentioned substrate was etched at a temperature of 253K (-20C) by operating the cooling means 69, the selectivity improved more than 50 and the working shape was very excellent without the side-etching and the overhanging (see Figure 9b).

An ion beam etching apparatus is known resembling above-mentioned ECR type etching apparatus, which is divided into a discharging part and an etching part. A positive ion is taken out from a plasma by supplying the negative potential on a grid. The positive ion is accelerated and bombarded on the object to be etched. An electron beam etching apparatus is also known. In this apparatus, negative ions and electrons are taken out by supplying the positive potential on the grid, and these are bombarded on the substrate. The above-mentioned apparatus can give similar effects if a reactive gas including a chlorine gas is used and the substrate is cooled.

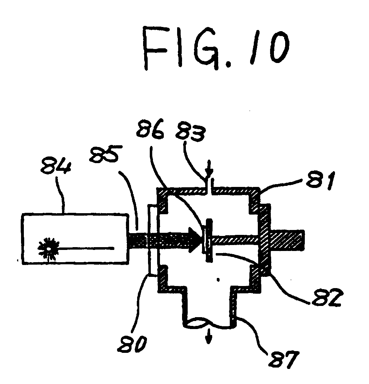

Figure 10 shows a photo-activating etching wherein an object holder 82 being able to cool the object is provided in a vacuum chamber 81 having a quartz window 80 through which ultraviolet rays are introduced. An etching gas is introduced in the vacuum chamber from a gas introducing nozzle 83 and emits ultraviolet rays from an ultraviolet ray source 84 such as an Eximer laser to an object 86. The gas is exhausted from an exhaust 87. In this apparatus, a chlorine gas and a fluorine gas are introduced in the vacuum chamber, and the pressure is several kilo pascals (tens of Torr). These gases receive the ultraviolet rays and separate chlorine. The etching of the polycrystalline material is carried out using chlorine radicals.

In normal temperature etching, phosphorous doped polycrystalline silicon reacts naturally with chlorine radicals. As a result, side-etching is caused and straight-edged etching is difficult. In the low temperature apparatus described above, etching is carried out on an object cooled to 253K (-20C) by the cooling means. The side etching is thus prevented and straight etching is achieved. It is considered that the etching rate of the radicals falls in response to cooling but parts irradiated by ultraviolet rays increase in temperature, and the reaction is consequently accelerated by light.

In the apparatus of figure 10 an Eximer laser (XeCl rays, XeCl₄ is 303nm) was used as the ultraviolet ray source, but a source of light having a wave length capable of separating the chlorine gas, e.g., a low pressure mercury lamp or a mercury zenon lamp may be used. Furthermore, cooling of the substrate is useful in other photo-activated etching using a vacuum violet rays of shorted wave length or SOR (Synchrotron Orbital Resonance) rays.

## Claims

1. A method in which a wafer (a) composed of a first film (21) and a second film (22) overlying the first film (21) is etched, said first film consisting of silicon oxide and the second film consisting of polycrystalline silicon, comprising the steps of:
disposing the wafer (9) in a vacuum chamber (1), cooling the wafer (9), and introducing a reactive gas including at least one halogen to the chamber (1) to etch the wafer (9) characterised in that the wafer (9) is cooled to a temperature between 243K and 263K during etching so that a thin film including at least one element of the first film selectively deposits on the first film.

2. The method of claim 1, wherein the reactive gas in the chamber is subjected to a magnetic field.

3. The method of claim 1 or 2, wherein the reactive gas is chlorine.

4. The method of any of the claims 1 to 3, wherein the pressure of the reactive gas is 0.1333Pa or more.

5. The method of any of the claims 1 to 4, wherein the reactive gas is activated by ultraviolet light.

6. The method of any of the claims 1 to 4, wherein the reactive gas is activated by SOR rays.

## Patentansprüche

1. Verfahren, bei dem ein Wafer (9), der eine erste Schicht (21) und eine über der ersten Schicht (21) liegende, zweite Schicht (22) aufweist, geätzt wird, wobei die erste Schicht Silicium-Oxid und die zweite Schicht polykristallines Silicium enthält, mit den folgenden Schritten:
Anordnen des Wafers (9) in einer Vakuumkammer (1), Abkühlen des Wafers (9) und Einleiten eines reaktionsfähigen Gases, welches zumindest ein Halogen umfaßt, in die Kammer (1), um den Wafer (9) zu ätzen, dadurch gekennzeichnet, daß der Wafer (9) während des Ätzvorgangs auf eine Temperatur zwischen 243 K und 263 K abgekühlt wird, so daß sich eine dünne Schicht, die zumindest ein Element der ersten Schicht enthält, selektiv auf der ersten Schicht absetzt.

2. Verfahren nach Anspruch 1, bei dem das reaktionsfähige Gas in der Kammer einem Magnetfeld ausgesetzt wird.

3. Verfahren nach Anspruch 1 oder 2, bei dem das reaktionsfähige Gas Chlorgas ist.

4. Verfahren nach einem der Ansprüche 1 bis 3, bei dem der Druck des reaktionsfähigen Gases 0,1333 Pa oder mehr beträgt.

5. Verfahren nach einem der Ansprüche 1 bis 4, bei dem das reaktionsfähige Gas durch ultraviolettes Licht aktiviert wird.

6. Verfahren nach einem der Ansprüche 1 bis 4, bei dem das reaktionsfähige Gas durch SOR-Strahlen aktiviert wird.

## Revendications

1. Procédé selon lequel une plaquette (9) composée d'un première pellicule (21) et d'une seconde pellicule (22) recouvrant la première pellicule (21) est gravée par corrosion, la première pellicule étant en oxyde de silicium et la seconde pellicule étant en silicium polycristallin, ce procédé comprenant les phases suivantes:
placer une plaquette (9) dans une chambre sous vide (1), refroidir la plaquette (9) et introduire un gaz réactif qui comprend au moins un halogène dans la chambre (1) pour graver par corrosion la plaquette (9),
caractérisé par le fait que la plaquette (9) est refroidie à une température comprise entre 234°K et 263°K pendant la gravure par corrosion de façon à ce qu'une fine pellicule comprenant au moins un élément de la première pellicule se dépose de manière sélective sur la première pellicule.

2. Procédé selon la revendication 1, dans lequel le gaz réactif dans la chambre est soumis à un champ magnétique.

3. Procédé selon la revendication 1 ou la revendication 2, dans lequel le gaz réactif est du chlore.

4. Procédé selon l'une quelconque des revendications 1 à 3, dans lequel la pression du gaz réactif est de 0,1333 Pa ou plus.

5. Procédé selon l'une quelconque des revendications 1 à 4, dans lequel le gaz réactif est activé par de la lumière ultraviolette.

6. Procédé selon l'une quelconque des revendications 1 à 4, dans lequel le gaz réactif est activé par des rayons SOR (produits par la résonance orbitale d'un synchrotron).
